# EUROPEAN PATENT APPLICATION

(11) **EP 3 163 634 A1**
(43) Date of publication of application: **03.05.2017**
(21) Application number: 16788404.8
(22) Date of filing: 12.07.2016
(51) Int. Cl.: H01L 33/22, H01L 33/10

(54) **LIGHT EMITTING ELEMENT**

(30) Priority: 17.07.2015 JP 2015143398; 01.10.2015 JP 2015195946
(71) Applicant: Scivax Corporation, Kawasaki-shi, Kanagawa 212-0032 (JP)
(72) Inventor: SUZAKI Yasumasa, Kawasaki-shi Kanagawa 212-0032 (JP); NAWATA Akifumi, Kawasaki-shi Kanagawa 212-0032 (JP); TANAKA Satoru, Kawasaki-shi Kanagawa 212-0032 (JP)
(74) Representative: Gille Hrabal
(86) International application number: PCT/JP2016/070515
(87) International publication number: WO 2017/014100

(57) **Abstract**

Provided is a light emitting device that includes a concavo-convex structure mainly utilizing the diffraction effect rather than the scattering effect of light, thereby improving the light extraction efficiency. A light emitting device includes a laminated part 8 where a semiconductor layer including a light emitting layer 84 is laminated, and a diffraction surface 2 comprising a concavo-convex structure which is formed at a boundary of any layer in the laminated part 8, and which reflects incident light emitted by the light emitting layer 84 in accordance with a Bragg's diffraction condition. The concavo-convex structure is formed in such a way that an inclination of a side wall of a convexity relative to the diffraction surface 2 is greater than 75 degrees.

## Description

### TECHNICAL FIELD

The present disclosure relates to a light emitting device that has an improved light extraction efficiency.

### BACKGROUND ART

Light Emitting Diodes (LEDs) basically employ a structure in which an n-type semiconductor layer, a light emitting layer, and a p-type semiconductor layer are laminated on a substrate. In addition, respective electrodes are formed on the p-type semiconductor layer and the n-type semiconductor layer, and a recombination of holes and electrons injected from the respective semiconductor layers causes the light emitting layer to emit light. As for such emitted light, a structure in which the light is extracted through the translucent electrode on the p-type semiconductor layer or through the substrate is employed. Note that the translucent electrode is a light transmissive electrode which is formed on the substantially entire surface of the p-type semiconductor layer, and which is formed of a thin metal film or a transparent conductive film.

According to LEDs employing such a structure, since the laminated structure is controlled in atomic level, the substrate is processed so as to have the flatness that falls in a mirror-surface level. Hence, the semiconductor layers, the light emitting layer, and the electrodes all on the substrate employ a laminated structure in parallel with each other. In this case, since the semiconductor layer has a greater refractive index than that of the substrate and that of the translucent electrode, a waveguide path that has the semiconductor layer held between the substrate and the translucent electrode is formed.

Hence, when light enters at an incident angle of greater than or equal to a predetermined critical angle relative to the electrode surface or the substrate surface, the light is reflected by the boundary between the electrode and the p-type semiconductor layer or the substrate surface, is propagated within the laminated structure of the semiconductor layer in the horizontal direction, and is trapped in the waveguide path. In addition, loss of light occurs during the propagation in the horizontal direction due to absorption. This may decrease an external quantum efficiency.

Conversely, Patent Document 1 discloses to form two-dimensional concavo-convex structures on a sapphire substrate, and to cause light to be reflected within the critical angle, thereby improving the external quantum efficiency.

### CITATION LIST

### PATENT LITERATURES

Patent Document 1: JP 2003-318441 A

### SUMMARY OF INVENTION

### TECHNICAL PROBLEM

However, conventional concavo-convex structures have a pitch, a height, etc., in a micro-order, and etching needs costs and a time. In addition, such structures mainly utilize the scattering of light, and do not proactively utilize diffraction of light. Still further, although Patent Document 1 auxiliary suggests the diffraction of light together with the scattering of light, the concavo-convex structure applied in this technology is not designed in precise consideration of the behavior of light, and thus the light extraction efficiency still has a leeway for improvement.

Hence, an objective is to provide a light emitting device that has the behavior of light taken into consideration, and has a concavo-convex structure formed so as to be suitable for diffraction of light, thereby improving a light extraction efficiency.

### SOLUTION TO PROBLEM

In order to accomplish the above objective, a light emitting device according to the present disclosure includes:
a laminated part where a semiconductor layer including a light emitting layer is laminated; and
a diffraction surface comprising a concavo-convex structure which is formed at a boundary of any layer in the laminated part, and which reflects incident light emitted by the light emitting layer in accordance with a Bragg's diffraction condition,
in which the concavo-convex structure is formed in such a way that an inclination of a side wall of a convexity relative to the diffraction surface is greater than 75 degrees.

In this case, it is preferable that the diffraction surface should include the concavo-convex structure arranged in a lattice pattern. The concavo-convex structure may be formed in a lattice pattern that is in a polygonal shape, such as a rectangular or square shape.

It is preferable that the diffraction surface should include a plurality of regions that have different directions of the lattice in the concavo-convex structure. For example, the plurality of regions may have directions of the lattice in the concavo-convex structure different equal angle by equal angle.

It is preferable that the diffraction surface should have a ratio S/P that is equal to or greater than 60 % where S is a width of a concavity and P is a pitch of the concavo-convex structure in a shortest pitch direction.

The diffraction surface may include the concavo-convex structure arranged in a checkered pattern. For example, the concavo-convex structure may include concavities and convexities in a polygonal shape arranged in the checkered pattern. An example polygonal shape is a rectangular or square shape.

It is preferable that the diffraction surface should include a plurality of regions that have different directions of the checkered pattern in the concavo-convex structure. For example, the diffraction surface may include a plurality of regions that have directions of the checkered pattern in the concavo-convex structure different equal angle by equal angle.

In addition, the diffraction surface may include the concavo-convex structure arranged in a line-and-space pattern.

It is preferable that the diffraction surface should include a plurality of regions that have different directions of the line-and-space pattern in the concavo-convex structure. For example, the diffraction surface may include a plurality of regions that have directions of the line-and-space pattern in the concavo-convex structure different equal angle by equal angle.

When the concavo-convex structure is in any shape of the lattice pattern, the checkered pattern, or the line-and-space pattern, when the diffraction surface includes the plurality of regions that have different directions of the concavo-convex structure, it is preferable that the plurality of regions should be arranged in such a way that the regions with the same direction of the concavo-convex structure are in sequence.

It is preferable that the diffraction surface should have the lower limit of the pitch of the concavo-convex structure which is equal to or greater than 1/4 times as much as the optical wavelength of the incident light, and have the upper limit which is equal to or smaller than 12 times as much as the optical wavelength of the incident light. In addition, it is preferable that the diffraction surface should have the lower limit of the height of the concavo-convex structure that is equal to or greater than 0.1 µm, and have the upper limit that is equal to or smaller than 1.5 µm.

### ADVANTAGEOUS EFFECTS OF INVENTION

According to the present disclosure, the light emitting device has the concavo-convex structure formed in consideration of a three-dimensional light reflection by a diffraction surface, and thus the light extraction efficiency is improvable in comparison with conventional technologies. In addition, since the dimension of the concavo-convex shape is small in comparison with those of conventional technologies, the costs for etching, etc., are reduced, while at the same time, the throughput is improved.

### BRIEF DESCRIPTION OF DRAWINGS

FIG. 1 is a schematic cross-sectional view illustrating a structure of a light emitting device according to the present disclosure;
FIG. 2 is a schematic cross-sectional view illustrating a structure of a diffraction surface according to the present disclosure;
FIGS. 3A, 3B are each a model diagram for explaining a simulation method for a light emitting device;
FIGS. 4A, 4B are each a model diagram for explaining a simulation method for a light emitting layer;
FIGS. 5A-5D are each a plan view illustrating a concavo-convex structure in a lattice pattern according to the present disclosure;
FIGS. 6A-6D are each a plan view illustrating another concavo-convex structure in a lattice pattern according to the present disclosure;
FIGS. 7A-7C are each a plan view illustrating a concavo-convex structure in a checker pattern according to the present disclosure;
FIG. 8 is a plan view illustrating a concavo-convex structure in a line-and-space shape according to the present disclosure;
FIGS. 9A, 9B are each a cross-sectional view illustrating a concavo-convex structure having a part formed of a material with a different refractive index according to the present disclosure;
FIGS. 10A-10C are each a diagram illustrating a structure of a light emitting device applied for a reliability evaluation in a simulation;
FIG. 11 is a graph illustrating a relationship between the planar shape of the concavo-convex structure and a light extraction efficiency;
FIG. 12 is a graph illustrating a relationship between the planar shape of the concavo-convex structure and a light extraction efficiency;
FIG. 13 is a diagram for explaining an inclination of the side wall of a convexity in the concavo-convex structure;
FIG. 14 is a graph illustrating a relationship between the inclination of the side wall of the convexity in the concavo-convex structure and the light extraction efficiency;
FIG. 15 is a graph illustrating a relationship between a ratio S/P where S is a width of a concavity and P is a pitch of the concavo-convex structure and the light extraction efficiency;
FIG. 16 is a planar photograph showing the concavo-convex structure according to the present disclosure in a production procedure;
FIGS. 17A, 17B are each a cross-sectional photograph showing the concavo-convex structure according to the present disclosure;
FIGS. 18A, 18B are planar photographs showing a transposition of a gallium nitride layer grown on a sapphire substrate that has the concavo-convex structure according to the present disclosure, and on a flat sapphire substrate, respectively; and
FIG. 19 is a schematic explanatory diagram illustrating a measuring method of the concavo-convex structure according to the present disclosure.

### DESCRIPTION OF EMBODIMENTS

A light emitting device 1 according to the present disclosure mainly includes a laminated part where at least a semiconductor layer 8 including a light emitting layer is laminated, and a diffraction surface 2 formed at any boundary between the layers in the laminated part.

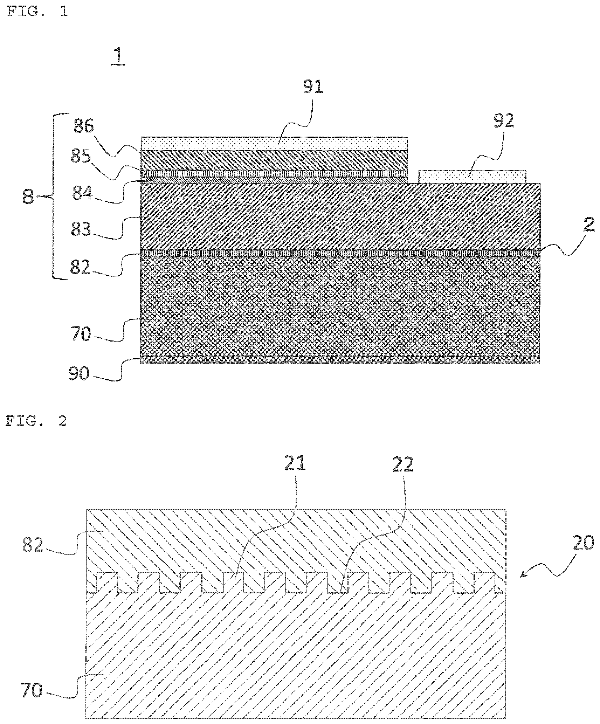

The laminated part means a part where the semiconductor layer 8, and a substrate are laminated together, and as illustrated in FIG. 1, includes a group-III nitride semiconductor layer, and a sapphire substrate 70. The light emitting device 1 illustrated in FIG. 1 has light to be extracted from the opposite side (hereinafter, referred to as a light extraction side) to the sapphire substrate 70, but light may be extracted from the sapphire-substrate-70 side. The group-III nitride semiconductor layer includes, for example, a buffer layer 82, an n-type GaN layer 83, a multiple quantum well active layer (light emitting layer 84), an electron block layer 85, and a p-type GaN layer 86 which are formed in this sequence from the sapphire-substrate-70 side. In addition, a p-side electrode 91 is formed on the p-type GaN layer 86, while an n-side electrode 92 is formed on the n-type GaN layer 83.

The buffer layer 82 is formed on the diffraction surface 2 of the sapphire substrate 70, and is formed of AlN. The buffer layer 82 may be formed by Metal Organic Chemical Vapor Deposition (MOCVD), sputtering, etc. The n-type GaN layer 83 that is a first conductivity type layer is formed on the buffer layer 82, and is formed of n-GaN. The multiple quantum well active layer (light emitting layer 84) that is the light emitting layer is formed on the n-type GaN layer 83, and is formed of GalnN/GaN. Injected electrons and holes causes this light emitting layer to emit light.

The electron block layer 85 is formed on the multiple quantum well active layer (light emitting layer 84), and is formed of p-AlGaN. The p-type GaN layer 86 that is a second conductivity type layer is formed on the electron block layer 85, and is formed of p-GaN. The layers from the n-type GaN layer 83 to the p-type GaN layer are formed by epitaxial growth of a group-III nitride semiconductor material. Note that the semiconductor layer 8 in the laminated part may employ other structures as long as it includes at least the first conductivity type layer and the second conductivity type layer, and an active layer that emits light by recombination of electrons and holes upon application of a voltage to the first and second conductivity type layers.

The p-side electrode 91 is formed on the p-type GaN layer 86, and is formed of a transparent material like Indium Tin Oxide (ITO). The p-side electrode 91 may be formed by vacuum deposition, sputtering, or Chemical Vapor Deposition (CVD), etc.

The n-side electrode 92 is formed by reaching the n-type GaN layer 83 by etching through the p-type GaN layer 86, and is formed on the exposed n-type GaN layer 83. The n-side electrode 92 is formed of, for example, Ti/Al/Ti/Au, and may be formed by vacuum deposition, sputtering, CVD, etc.

The light emitting device 1 may have a reflection film 90 which is formed of Al, etc., and which is formed at the opposite side to the light extraction side, e.g., the back surface side of the sapphire substrate 70. In the case of the light emitting device 1 illustrated in FIG. 1, the boundary surface between the reflection film 90 and the sapphire substrate 70 serves as the reflection surface, and light having passed through the sapphire substrate 70 is reflected by the reflection surface. Hence, the light having passed through the sapphire substrate 70 can be returned to the light extraction side.

The diffraction surface is a layer contained in the laminated part, i.e., a layer formed at the boundary of either the semiconductor layer 8 or the substrate, and including a concavo-convex structure 20 formed so as to reflect incident light emitted from the light emitting layer in accordance with the Bragg's diffraction condition. The boundary mainly means the uppermost layer of the semiconductor layer 8 or the lowermost layer thereof, but may be provided at the middle location in the semiconductor layer 8 or the surface of the substrate. As illustrated in FIG. 1, when the diffraction surface 2 is formed at the boundary between the laminated part and the sapphire substrate 70, the sapphire substrate 70 has a c-plane ({0001}) on which a nitride semiconductor material is to be grown, and which is at the front surface side. This plane becomes the diffraction surface 2. As illustrated in FIG. 2, the plurality of concavo-convex structures 20 regularly arranged at a constant pitch is formed on the diffraction surface 2. In addition, convexities 21 of the concavo-convex structures 20 accomplish a light diffraction action.

When a critical angle causing a total reflection is defined as θ_{c}, the concavo-convex structure 20 is formed so as to reflect incident light with an incident angle of θ_{C} degree to 90-θ_{C} degrees at an outgoing angle that is equal to or smaller than ±θ_{C} degrees. However, the outgoing angle by diffraction is determined in accordance with the wavelength of incident light. Hence, when the incident light is not monochromatic light, it is desirable that the concavo-convex structure 20 should be formed so as to reflect the incident light at the outgoing angle which is equal to or smaller than ±θ_{C} within a wavelength range that is the half bandwidth of the wavelength of the incident light. In addition, the total light reflection occurs when light enters from a medium with a high refractive index to a medium with a low refractive index. Hence, the concavo-convex structure 20 includes the convexity 21 formed of a medium with a low refractive index, and the concavity 22 formed of a medium with a high refractive index among media across the boundary. Hence, as for the concavo-convex structure 20 in FIG. 2, since the sapphire substrate 70 has a lower refractive index than that of the buffer layer 82, the part formed of the material at the sapphire-substrate side becomes the convexity 21, while the part filled with the material at the buffer-layer-82 side becomes the concavity 22.

Such a concavo-convex structure may be formed by conventionally well-known techniques. For example, a resist film may be formed on the substrate where the concavo-convex structure is to be formed, a predetermined pattern may be transferred to the resist film by imprinting, and the concavo-convex structure may be formed on the substrate by etching.

In this case, conventionally, a pyramid shape and a trapezoidal pyramid shape having the upper end cut out are known as the shapes of the concavo-convex structure. However, those are mainly designed in consideration of the scattering of light, and a design having the diffraction of light taken into consideration and improving a light extraction efficiency has not been known so far. This is because a calculation for the behavior of light with respect to diffraction is complex, making a simulation difficult. For example, a Rigorous Coupled Wave Analysis (RCWA) scheme, and a Finite Difference Time Domain (FDTD) scheme are known as simulation schemes for the diffraction of light by concavo-convex structure. Since the RCWA scheme handles a single planar wave, the FDTD scheme is generally applied for a simulation of the light extraction efficiency of an LED. In the case of FDTD scheme, however, the amount of calculation is quite large, needing a long time for calculation, and a dimension that can be handled three-dimensionally is merely several µm³. Hence, an application to LEDs in an actual dimension is difficult, and this scheme is utilized for simply checking the tendency by two-dimensional (in the case of FIG. 1, the vertical direction and the horizontal direction) simulation. Hence, under such a circumference, concavo-convex structures that is capable of improving the light extraction efficiency are not designed having a three-dimensional (in the case of FIG. 1, in addition to the vertical direction and the horizontal direction, the depthwise direction) light behavior taken into consideration. In contrast, the inventors of the present disclosure keenly examined and studied, made a devisal on simulation schemes to successfully carry out a simulation having the three-dimensional light behavior taken into consideration, and eventually found a concavo-convex structure that has a higher light extraction efficiency than that of conventional technologies.

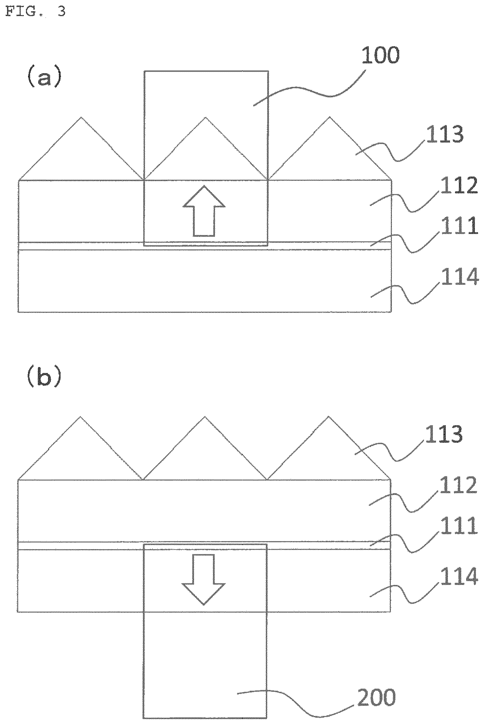

In this case, an explanation will be given of such a simulation method with reference to an LED illustrated in FIGS. 3A, 3B. The LED illustrated in FIGS. 3A, 3B includes a light emitting layer 111, an upper layer 12 employing a uniform structure with the consistent and continuous refractive index distribution formed at an upper-model-100 side, concavo-convex structures 113 formed on the surface of the upper layer 12, and a lower layer 14 employing a uniform structure with the consistent and continuous refractive index distribution formed at a lower-model-200 side.

This method mainly includes:
a first step of, first of all, dividing the structure of the LED into an upper model 100 at the one side with reference to the position of the light emitting layer 111, and a lower model 200 at the other side, taking light emitted from the light emitting layer 111 as incident light, and calculating, by the RCWA scheme, information A₁ on the diffraction efficiency of transmitted light having passed through the upper model 100 of the LED, information B₁ on the diffraction efficiency of reflected light reflected by the upper model 100 and returned to the boundary, information C₁ on the diffraction efficiency of reflected light reflected by the lower model 200 of the LED and returned to the boundary, and information D₁ on the diffraction efficiency of transmitted light having passed through the lower model 200;
a second step of calculating, by the RCWA scheme based on the information B₁ and the information C₁, and with light having diffraction efficiency information Cₖ₋₁ being as a light source, information Aₖ on the diffraction efficiency of the transmitted light having passed through the upper model 100, information on the diffraction efficiency of the reflected light reflected by the upper model 100 and returned to the boundary, and calculating, by the RCWA scheme with light having diffraction efficiency information Bₖ₋₁ being as a light source, information Cₖ on the diffraction efficiency of the reflected light reflected by the lower model 200 and returned to the boundary, and information Dₖ on the diffraction efficiency of the transmitted light having passed through the lower model 200 (however, the value k in the second step is a natural number equal to or greater than two and equal to or smaller than n, and the calculations of Bₙ and Cₙ are unnecessary when k = n); and
a third step of aggregating the pieces of information A₁ to An and D₁ to Dₙ, to calculate the light extraction efficiency. The structure of the LED is determinable based on the calculation result of the light extraction efficiency through this simulation.

In this case, the LED structure means a necessary structure for the calculation by the RCWA scheme, is a cross-sectional structure in the vertical direction to the laminated part including the light emitting layer 111, and is a periodic structure. In addition, the diffraction efficiency is a value indicating how much energy the diffracted light possesses among the energies of the incident light. Still further, the light extraction efficiency is a value indicating the energy of the extracted light when the total energy of output light by the light source is defined as 1.

Yet still further, the calculation in the first step, the calculation in the second step, and the calculation in the third step may be carried out using a software and a computer. In this case, in the first step, information on the shape of the cross-sectional structure in the vertical direction to the light emitting layer of the LED, the pitch thereof, the thickness of each layer including the light emitting layer, the refractive index and extinction coefficient of the material of each layer, and light to be emitted by the light emitting layer are input to the computer, and the pieces of information A₁, B₁, C₁, D₁ are obtained by the computer calculation based on the RCWA scheme. In the second step, the information Cₖ₋₁ is input to the computer as the information on the light source of the upper model, the information Bₖ₋₁ is input to the computer as the information on the light source of the lower model, and the pieces of information Aₖ, Bₖ, Cₖ, Dₖ are obtained by the computer calculation based on the RCWA scheme. In the third step, the computer calculates the light extraction efficiency based on the pieces of information A₁ to Aₙ and D₁ to Dₙ. The information on the light emitted by the light emitting layer is information necessary for the calculation by the RCWA scheme, such as the light emission wavelength, the light intensity, the pitch of the incident light angle, and whether the direction in which the light is to be extracted is the upper model side, the lower model side, or both sides.

The first to third steps will be explained in further detail below.

### <First Step>

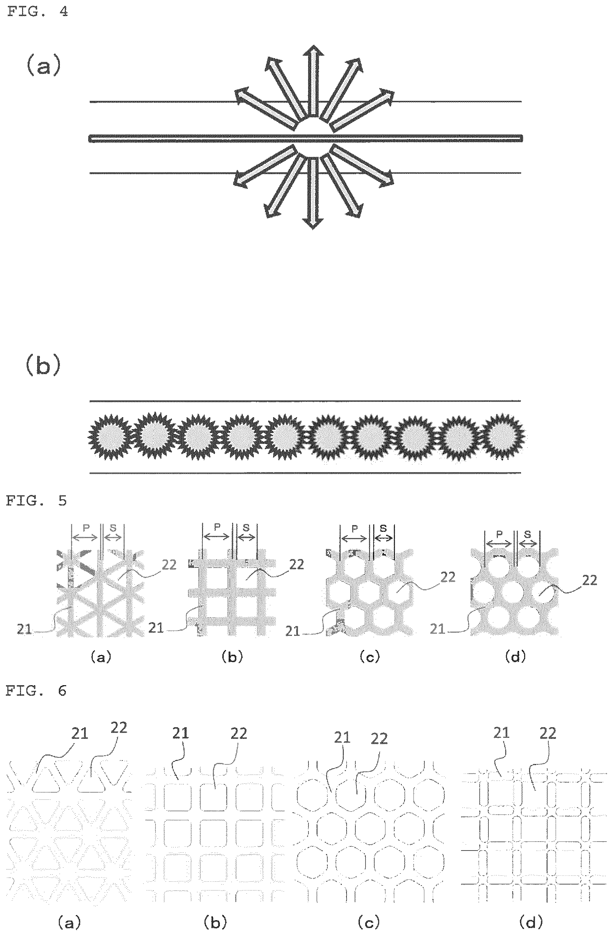

In the first step, as illustrated in FIG. 4A, it is assumed that light emitted by the light emitting layer 111 is a collection of planar waves spreading in an isotropic manner. This is because, in the case of the FDTD scheme, as illustrated in FIG. 4B, it is assumed that the light source is a collection of dot light sources, but the RCWA scheme can handle only a single planar wave. This planar wave has the consistent energy at any angles.

In addition, as illustrated in FIGS. 3A, 3B, with the position of the intermediate light emitting layer 111 being as an boundary, the LED structure is divided into the two models that are the upper model 100 at the one side of such a structure, and the lower model 200 at the other side thereof.

Next, the diffraction efficiency of the diffracted light caused by the upper model 100 and by the lower model 200 relative to the light (the incident light) from light emitting layer 111 is calculated by the RCWA scheme. More specifically, for each incident angle of the incident light, the diffraction efficiency is calculated for each angle of the diffracted light. Such a calculation can be carried out using a software and a computer that are capable of a calculation based on the RCWA scheme.

In this case, the diffracted light is classified into four types of the transmitted light that are transmitted light having passed through the upper model 100, the reflected light reflected by the upper model 100 and returned to the boundary, the reflected light reflected by the lower model 200 and returned to the boundary, and the transmitted light having passed through the lower model 200. Next, for each incident angle of the incident light, the diffraction efficiency per an angle of diffracted light is calculated and aggregated, thereby obtaining the pieces of information A₁ on the diffraction efficiency of the transmitted light having passed through the upper model 100, B₁ on the diffraction efficiency of the reflected light by the upper model 100, C₁ on the diffraction efficiency of the reflected light by the lower model 200, and D₁ on the diffraction efficiency of the transmitted light having passed through the lower model 200.

Note that the interval of the incident angle may be set as appropriate in accordance with the required precision for the light extraction efficiency simulation, and the smaller the interval of the incident angle is, the more the light extraction efficiency can be simulated precisely. For example, the calculation may be made at the interval of 1 degree by 1 degree as for the incident angle of incident light. In addition, the interval of the angle of diffracted light may be also approximated as appropriate in accordance with the required precision for the light extraction efficiency simulation.

### <Second Step>

The transmitted lights having passed through the upper model and the lower model in the first step are lights extracted from the LED. Hence, the information A₁ on the transmitted light becomes a part of the information on the light extraction efficiency with respect to the upper side, while the information D₁ on the transmitted light becomes a part of the information on the light extraction efficiency with respect to the lower side.

In addition, the reflected light by the upper model 100 in the first step is considerable as a light source for the lower model 200, and the reflected light by the lower model 200 is considerable as a light source for the upper model 100.

Hence, in the second step, the light with the information C₁ is considered as incident light to the upper model 100, and like the first step, the information A₂ on the diffraction efficiency of the transmitted light having passed through the upper model 100 and the information B₂ on the diffraction efficiency of the reflected light are calculated based on the RCWA scheme. Still further, the light with the information B₁ is considered as incident light to the lower model 200, and like the first step, the information A₂ on the diffraction efficiency of the transmitted light having passed through the lower model 200 and the information B₂ on the diffraction efficiency of the reflected light are calculated based on the RCWA scheme.

Consequently, the information A₂ on the transmitted light becomes a part of the information on the light extraction efficiency with respect to the upper side, while the information D₂ on the transmitted light becomes a part of the information on the light extraction efficiency with respect to the lower side. In addition, like the case as explained above, the reflected light at the upper side is considerable as the light source for the lower model 200, while the reflected light at the lower side is considerable as the light source for the upper model 100.

By calculating the information on the diffraction efficiencies of the transmitted light and of the reflected light in sequence based on the information B₁ and the information C₁ as explained above, with the light that has the information Cₖ₋₁ being as the light source, the information Aₖ on the diffraction efficiency of the transmitted light having passed through the upper model 100, and the information Bₖ of the diffraction efficiency of the reflected light by the upper model 100 are respectively calculatable by the RCWA scheme. In addition, with the light that has the information Bₖ₋₁ being as the light source, the information Cₖ on the diffraction efficiency of the reflected light by the lower model 200 and the information Dₖ of the diffraction efficiency of the transmitted light having passed through the lower model 200 are respectively calculatable by the RCWA scheme. Note that in this case, such a calculation can be carried using a software and a computer capable of the calculation based on the RCWA scheme.

In addition, the value k in the second step is a natural number equal to or greater than two and equal to or smaller than n, and the calculation is continuously carried out until k = n. Still further, when k = n, since Bₙ and Cₙ are unnecessary as the information on the light extraction efficiency to be calculated in the third step, the calculations of those pieces of information may be omitted. The natural number n may be set as appropriate in accordance with the required precision for the light extraction efficiency simulation, and the greater the number n is, the more the light extraction efficiency can be simulated precisely, but the calculation time becomes long. As for an example way of setting of the natural number n, the value of k may be set as the value of n when a difference between the total of the diffraction efficiencies based on the pieces of information A₁ to Aₖ₋₁ and D₁ to Dₖ₋₁, and the total of the diffraction efficiencies based on the pieces of information A₁ to Aₖ and D₁ to Dₖ becomes equal to or smaller than a certain ratio relative to the total energy of the light source, e.g. , equal to or smaller than 1 %.

### <Third Step>

In the third step, the pieces of information A₁ to Aₙ and D₁ to Dₙ obtained in the first step and the second step are aggregated. Next, the energy of the extracted light when the total energy of the light source is defined as 1 is calculated, and thus the light extraction efficiency of the LED is calculatable. Such a calculation can be carried out using conventionally well-known software and computer.

The light extraction efficiencies with respect to various LED structures are calculated in this way, and the structure of the LED can be determined based on the calculation result to produce the LED.

Next, an explanation will be given of the concavo-convex structure found through the above simulation method. First of all, conventional technologies mainly utilize the scattering of light rather than the diffraction of light. Hence, it is thought that the inclination of the side wall of the convexity is preferably equal to or smaller than 75 degrees. According to the present disclosure, however, the diffraction of light is mainly utilized, and in order to maximize the diffraction effect, it is preferable that the concavo-convex structure should have the inclination of the side wall of the convexity relative to the diffraction surface which is close to 90 degrees. Needless to say, when imprinting is applied to form the concavo-convex structure, in view of the demolding performance, the concavo-convex structure may need a slight inclination (mold-release slope). However, in order to improve the light extraction efficiency greater than those of conventional technologies, it is preferable that the inclination should be greater than 75 degrees, more preferably, equal to or greater than 80 degrees, and further more preferably, equal to or greater than 85 degrees. Note that the inclination of the side wall of the convexity means the inclination of the side wall of the convexity relative to the diffraction surface, and is an inclination at the keen-angle side.

As illustrated in FIGS. 5A-5D, it is preferable that the diffraction surface should have the concavo-convex structures formed in a lattice pattern. The lattice pattern has concavities surrounded by a frame of convexity and arranged regularly. It is preferable that the shape of lattice (planar shape of concavity) should be a polygonal shape, such as a triangular shape, a rectangular shape, or a hexagonal shape. Among those shapes, the preferable shape is a rectangular shape, such as a square, an elongated rectangle, a rhombic shape, or a parallelogram shape. The square is the most preferable shape since it can make the pitch of the concavo-convex structure uniform which is important to control the diffraction.

In the present disclosure, the term pitch P means, as illustrated in FIGS. 5A-5D, the minimum length of the repeated unit structure contained in the concavo-convex structure. For example, FIG. 5A illustrates a case in which the gap between linear structures in the repeated unit structure contained in the concavo-convex structure is the minimum length, and thus this is set as the pitch P.

It is preferable that the pitch of the concavo-convex structure on the diffraction surface should be equal to or greater than 1/4 times as much as the optical wavelength, more preferably, equal to or greater than 1/2 times, and further more preferably, equal to or greater than 1 time. When, however, the pitch is too wide, etching needs costs and a time. Hence, it is preferable that the pitch should be equal to or smaller than 12 times as much as the optical wavelength, more preferably, equal to or smaller than 10 times, and further more preferably, equal to or smaller than six times. Note that the optical wavelength means, as for the lower limit value, the optical wavelength at a layer with a smaller refractive index in both layers that form the boundary of the concavo-convex structure, and as for the upper limit value, the optical wavelength in the layer with a larger refractive index in the layers that form the boundary of the concavo-convex structure.

It is preferable that, on the straight line in the shortest pitch direction of the concavo-convex structure, a ratio S/P of a width S of the concavity relative to the pitch P should be equal to or greater than 60 %, more preferably, equal to or greater than 65 %, and further more preferably, equal to or greater than 70 %. When, however, the width of the convexity is too narrow, light is not sufficiently diffracted. Hence, it is preferable that the width of the convexity of the concavo-convex structure should be at least equal to or greater than 1/4 times as much as the optical wavelength of light to be reflected, and more preferably, equal to or greater than 1/2 times. In view of this fact, it is preferable that the ratio S/P should be equal to or greater than 60 % and equal to or smaller than 80 %, more preferably, equal to or greater than 65 % and equal to or smaller than 75 %. In addition, it is preferable that the height of the concavo-convex structure should be equal to or greater than 0.1 µm, more preferably, equal to or greater than 0.2 µm, and further more preferably, equal to or greater than 0.3 µm. When, however, the height is too high, etching needs costs and a time. Hence, it is preferable that the height should be equal to or smaller than 1.5 µm, and more preferably, equal to or smaller than 1.2 µm. In addition, depending on the wavelength of light, the height may be equal to or smaller than 0.9 µm, or equal to or smaller than 0.8 µm.

When the semiconductor layer 8 is formed, and when the shape of the lattice is a polygonal shape, a crystal growth does not advance well at a corner part, resulting in a pore and a defect. Hence, in view of the easiness of the crystal growth, as illustrated in FIGS. 6A-6C, the corner part may be in curved shape or a chamfered shape like a straight line that can buffer the corner part. In this case, however, it is preferable that the length of the straight line part of the side should be equal to or greater than 60 % of the length of the side of the polygonal shape not subjected to chamfering. Note that the polygonal shape not subjected to chamfering can be identified by elongating the straight line part of the side. Alternatively, the length of the side of the polygonal shape not subjected to chamfering may be calculated based on the pitch P. In addition, as illustrated in FIG. 6D, the corner parts of the adjacent polygonal shapes may be interconnected with each other to obtain a shape that has only sides without a corner.

In addition, it is preferable that the diffraction surface should include a plurality of regions in which the direction of the lattices in the concavo-convex structure differs from that of the other region. The term region means a divided piece of the diffraction surface by a predetermined size, and the directions of the lattices in the concavo-convex structure are oriented within the same region. Since incident light from the light emitting layer is directed in various directions, by providing the plurality of regions that have different directions of lattices in the concavo-convex structure, the diffraction by the diffraction surface is ensured. Hence, it is preferable that the regions should be arranged in such a way that the regions with the same direction of the concavo-convex structures are not in sequence on an arbitrary straight line. For example, the maximum number of the sequential concavo-convex structures is set to be equal to or smaller than 500 pitches within the same region, and more preferably, equal to or smaller than 200 pitches. When, however, the size of the region is too small, a sufficient reflection by the concavo-convex structure is not accomplishable. Hence, it is preferable that sequential concavo-convex structures should be formed within the region by at least equal to or greater than the pitch enabling a sufficient light reflection, and for example, the pitch of the concavo-convex structure may be equal to or greater than 50, and more preferably, equal to or greater than 100.

The direction of the lattices in each region may be optional, but in order to cause incident light in any directions to be surely diffracted, it is preferable that a plural types of regions should be formed which have lattice directions different equal angle by equal angle. When, for example, the shape of the lattice is a triangle, two types of regions may be formed which have different lattice directions in the concavo-convex structures 30 degrees by 30 degrees, when the shape of the lattice is a rectangle, four types of regions that have different lattice directions in the concavo-convex structures 45 degrees by 45 degrees may be formed, and when the shape of the lattice is a regular hexagon, two types of regions that have different lattice directions in the concavo-convex structures 60 degrees by 60 degrees may be formed.

More preferably, in order to surely cause light to be diffracted from any directions, it is preferable that the plurality of regions that have different lattice directions should be arranged as even as possible.

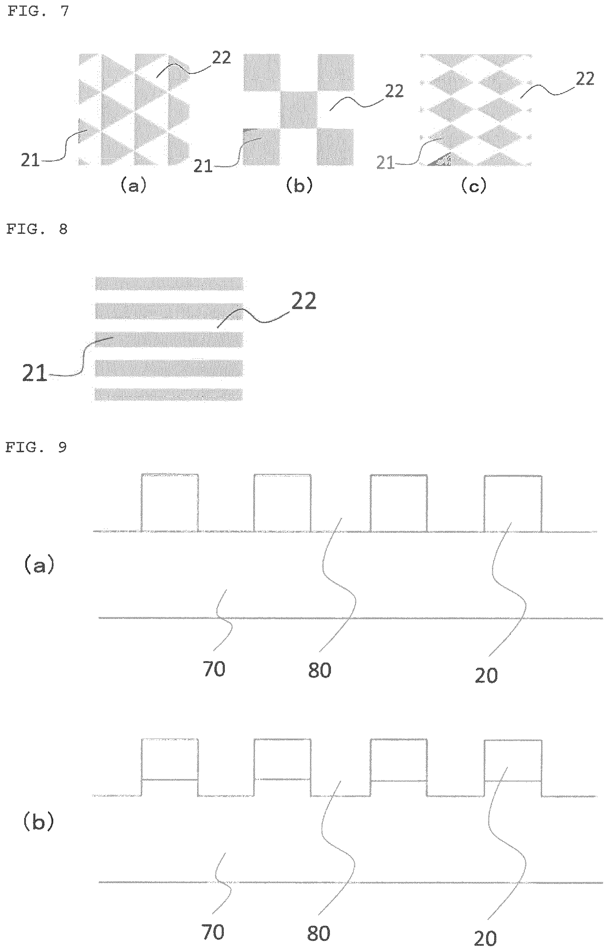

As illustrated in FIGS. 7A-7C, as another diffraction surface, the concavo-convex structures may be arranged in a checkered pattern (checked shape). The checkered pattern means a shape that has the convexity and the concavity which have the same planar shape and which are arranged alternately. There is an advantage such that the convexity with a high aspect ratio is easily formable in comparison with the lattice pattern, and is advantageous when it is desirable to increase the height of the convexity. Example shapes (planar shapes of the convexity and concavity) of the checkered pattern are polygonal shapes, such as a triangular shape, and the rectangular shape. Among those shapes, the preferable shape is a rectangular shape, such as a square, an elongated rectangle, a rhombic shape, or a parallelogram shape. The square is the most preferable shape since it can make the pitch of the concavo-convex structure uniform.

In this case, it is preferable that the diffraction surface should include a plurality of regions which have different directions of the checkered pattern in the concavo-convex structures from that of the other region. The term region in this case means a range where the directions of the checkered patterns of the concavo-convex structures are in sequence on the diffraction surface. Since incident light from the light emitting layer is directed in various directions, by providing the plurality of regions that have different checkered pattern directions in the concavo-convex structures, the diffraction by the diffraction surface is ensured. Hence, it is preferable that the regions should be arranged in such a way that the regions with the same direction of the concavo-convex structures are not in sequence on an arbitrary straight line. For example, the maximum number of the sequential concavo-convex structures is set to be equal to or smaller than 500 pitches within the same region, and more preferably, equal to or smaller than 200 pitches. When, however, the size of the region is too small, a sufficient reflection by the concavo-convex structure is not accomplishable. Hence, it is preferable that sequential concavo-convex structures should be formed within the region by at least equal to or greater than the pitch enabling a sufficient light reflection, and for example, the pitch of the concavo-convex structure may be equal to or greater than 50, and more preferably, equal to or greater than 100.

In addition, the direction of checkered pattern in each region may be optional, but in order to surely cause incident light to be diffracted from any directions, it is preferable that a plural types of regions should be formed which have checkered pattern directions different equal angle by equal angle. When, for example, the shape of the checkered pattern is a triangle, two types of regions may be formed which have different checkered pattern directions 30 degrees by 30 degrees, when the shape of the checkered pattern is a rectangle, four types of regions that have different checkered pattern directions 45 degrees by 45 degrees may be formed, and when the shape of the checkered pattern is a square, two types of regions that have different checkered pattern directions 45 degrees by 45 degrees may be formed.

Still further, in order to surely cause light to be diffracted from any directions, it is preferable that the plurality of regions that have different checkered pattern directions should be arranged as even as possible.

Yet still further, as illustrated in FIG. 8, as the other diffraction surface, the concavo-convex structures may be disposed in a line-and-space pattern. The line-and-space pattern means liner concavities and convexities arranged alternately.

In addition, it is preferable that the diffraction surface should include a plurality of regions in which the direction of the line-and-space pattern in the concavo-convex structure differs from that of the other region. The term region means a divided piece of the diffraction surface by a predetermined size, and the directions of the line-and-space pattern in the concavo-convex structure are oriented within the same region. Since incident light from the light emitting layer is directed in various directions, by providing the plurality of regions that have different line-and-space pattern directions in the concavo-convex structure, the diffraction by the diffraction surface is ensured. Hence, it is preferable that the regions should be arranged in such a way that the regions with the same direction of the concavo-convex structures are not in sequence. For example, the maximum number of the sequential concavo-convex structures is set to be equal to or smaller than 500 pitches within the same region, and more preferably, equal to or smaller than 200 pitches. When, however, the size of the region is too small, a sufficient reflection by the concavo-convex structure is not accomplishable. Hence, it is preferable that sequential concavo-convex structures should be formed within the region by at least equal to or greater than the pitch enabling a sufficient light reflection, and for example, the pitch of the concavo-convex structure may be equal to or greater than 50, and more preferably, equal to or greater than 100.

In addition, the line-and-space pattern direction may be optional, but in order to surely cause incident light to be diffracted from any directions, a plural types of regions that have line-and-space pattern directions different equal angle by equal angle may be formed. For example, two regions that have different line-and-space pattern directions 90 degrees by 90 degrees may be formed.

In the above concavo-convex structure in the lattice pattern, the checkered pattern, and the line-and-space pattern, when the gap between the concavities is too narrow, this may disturb a crystal growth. Hence, it is preferable that the gap between the concavities should be equal to or greater than 200 nm. Still further, it is preferable that the width of the convexity in the concavo-convex structure should be equal to or greater than 1/4 times as much as the optical wavelength of light to be reflected, and more preferably, equal to or greater than 1/2 times. This is because when the width of the concavity is not equal to or greater than at least 1/4 times, a sufficient light diffraction is not accomplishable.

The greater the difference in refractive index of the materials across the diffraction surface is, the more the light diffraction is likely to occur. Hence, when the concavo-convex structure 20 is formed between the substrate and the semiconductor layer 8, as illustrated in FIG. 9A or 9B, it is preferable that at least a part of the concavo-convex structure 20 should be formed of a material that accomplishes a difference in refractive index between the semiconductor layer 80 and the concavo-convex structure 20 which is greater than a difference in refractive index between the substrate 70 and the semiconductor layer 80. When, for example, the concavo-convex structure 20 is formed between the sapphire substrate 70 and the semiconductor layer 80 formed of gallium nitride (GaN), it is preferable that at least a part of the concavo-convex structure 20 should be formed of silicon dioxide (SiO₂). Since the refractive index of gallium nitride is substantially 2.5, that of sapphire is substantially 1.78, and that of silicon dioxide is substantially 1.45, by forming some concavities or convexities of the concavo-convex structure 20 of silicon dioxide, the difference in refractive index relative to gallium nitride is increased. In addition, at least a part of the concavo-convex structure 20 may be formed of silicon oxynitride (SiON). Since silicon oxynitride decreases the refractive index when containing a large amount of oxygen element, and increases the refractive index when containing a large amount of nitrogen element, the refractive index is adjustable by the ratio between oxygen and nitrogen. Note that it is necessary to select a material for the concavo-convex structure 20 which enables the semiconductor layer 80 to be grown on the substrate 70. In addition, the concavo-convex structure 20 can be produced by any schemes, and for example, semiconductor manufacturing technologies, such as lithography, imprinting, and etching, are applicable.

Next, a relationship between the concavo-convex structure on the diffraction surface and the light extraction efficiency was simulated. A software DiffractMOD available from Synopsys, Inc., was applied for the simulation.

### [Reliability Evaluation]

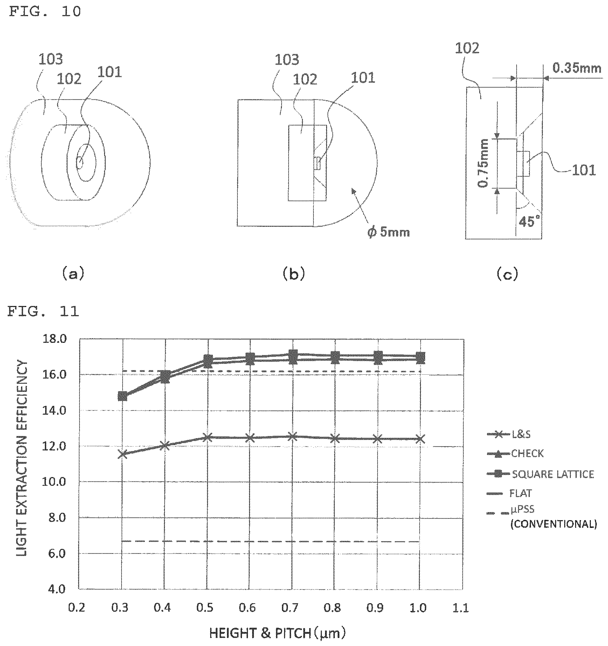

First, in order to verify the reliability of the simulation, a simulation was made for a flat light emitting device that had no concavo-convex structure, and for a micro-PSS that is conventionally known as having the best light extraction efficiency, and the simulation results were compared with actual measured values. As illustrated in FIG. 10A, the light emitting element applied for the actual measurement included an LED chip 101, a reflector 102, and a resin mold 103. The applied LED chip 101 had an area of 0.5 mm by 0.5 mm, and a thickness of 0.15 mm. The applied reflector 102 had a hole in which the LED chip 101 was disposed, and which was formed in a shape spreading as a circular conical trapezoid, and a silver plating was applied on the surface. The diameter of the upper surface (where the LED chip 101 was disposed) of the circular conical trapezoid was 0.75 mm, the height was 0.35 mm, and the angle of the side surface relative to the upper surface was 45 degrees. In addition, the applied resin mold 103 was a resin which had a refractive index of 1.42, and covered the LED chip 101 and the reflector 102. The light emitting direction of the LED was in a semi-spherical shape that had a diameter of 5 mm. Table 1 shows the simulation results and the actual measured values.

**[Table 1]**

| | Flat | µ-PSS |
|---|---|---|
| Simulation Result | 34.6 | 52.5 |
| LED Evaluation Measured Value | 35.0 | 46.8 |

As shown in table 1, the light extraction efficiency showed the substantially same value as that of the actually produced sample, and thus the reliability of the simulation was verified. Since this example was to verify the reliability of the simulation for the flat light emitting device that has no concavo-convex structure and for the micro-PSS, other factors relating to the light extraction efficiency than PSS, such as a chip size, a thickness, and the refractive index of the resin mold, are not taken into consideration on the simulation.

### [First Example]

First of all, the relationship between the shape of the concavo-convex structure and the light extraction efficiency was simulated. In this case, as for the laminated part of the LED including the semiconductor layer and the substrate, a general model was applied. In addition, the diffraction surface was disposed at the boundary between the substrate (refractive index: 1.78) and the semiconductor layer (refractive index: 2.5), and the shape was as follows:
L & S: the line-and-space pattern illustrated in FIG. 8 was applied, and the width of the line was 40 % of the pitch;
Check (Checkered pattern): the triangular checkered pattern illustrated in FIG. 7A was applied; and
Lattice: the lattice pattern illustrated in FIG. 5B and including the square concavity was applied, and the width of the line was 30 % of the pitch.

The concavo-convex structures had the same pitch and height, and the simulation was made for eight types which had different pitches from 0.3 µm to 1.0 µm, for each 0.1 µm.

In addition, as comparative examples, a simulation was also made for a flat light emitting device that had no concavo-convex structure, and for the micro-PSS conventionally known as having the best light extraction efficiency. The concavo-convex structure on the micro-PSS included circular cones which had a diameter of the bottom surface that was 2.7 µm, and the height of 1.6 µm, and arranged in a triangular shape. The inclination of the side wall of the convexity in the concavo-convex structure relative to the diffraction surface was 90 degrees for both the example and the comparative example. Table 2 and FIG. 11 show the results of above simulation.

**[Table 2]**

| Concavo-convex Structure | | Light Extraction Efficiency | | |
|---|---|---|---|---|
| Pitch (µm) | Height (µm) | L&S | Check | Sq. Lattice |
| 0.3 | 0.3 | 11.5 | 14.8 | 14.8 |
| 0.4 | 0.4 | 12.0 | 15.8 | 16.0 |
| 0.5 | 0.5 | 12.5 | 16.6 | 16.8 |
| 0.6 | 0.6 | 12.5 | 16.8 | 17.0 |
| 0.7 | 0.7 | 12.6 | 16.8 | 17.2 |
| 0.8 | 0.8 | 12.4 | 16.9 | 17.1 |
| 0.9 | 0.9 | 12.4 | 16.8 | 17.1 |
| 1.0 | 1.0 | 12.4 | 16.9 | 17.0 |

| | | | | |
|---|---|---|---|---|
| Flat: Light extraction efficiency was 6.7. Micro-PSS: Light extraction efficiency was 16.2. | | | | |

In addition, it becomes clear from table 2 and FIGS. 10A-10C that, when the pitch of the concavo-convex structure and the height thereof are equal to or greater than 0.5 µm, the concavo-convex structures in the checkered pattern (triangle) and the lattice pattern (square) have a higher light extraction efficiency than that of the micro-PSS conventionally known as having the best light extraction efficiency. In particular, the concavo-convex structure in a lattice pattern (square) has an excellent light extraction efficiency, and when the height and the pitch are both equal to or greater than 0.7 µm, the light extraction efficiency is improved by 6.2 % in comparison with that of the micro-PSS. In addition, the line-and-space pattern also accomplishes a high light extraction efficiency to some level although not the same level as the micro-PSS. However, the line-and-space pattern has an advantage such that it can be easily processed in comparison with other shapes including the micro-PSS.

### [Second Embodiment]

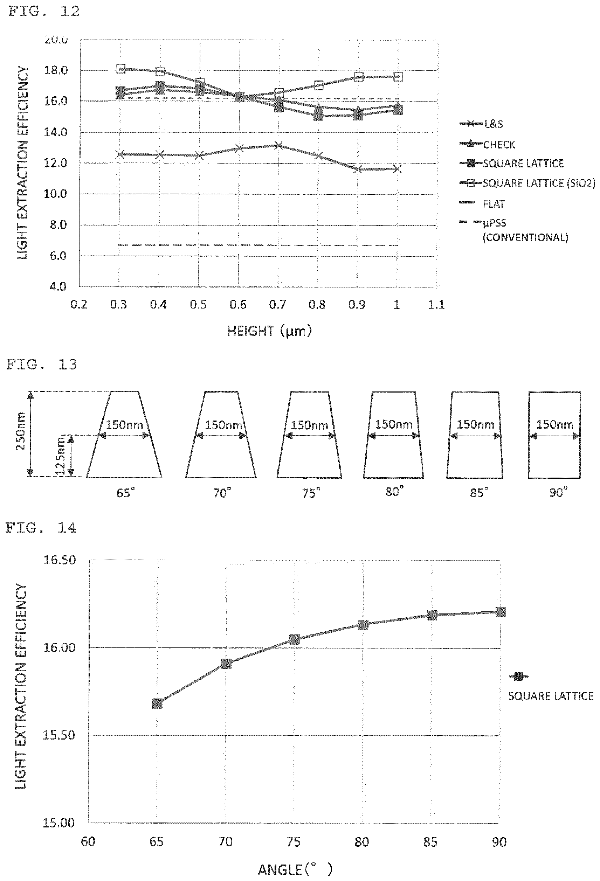

Next, the pitch was stationary set to 0.5 µm for the concavo-convex structures in the line-and-space pattern, the checkered pattern (triangle), and the lattice pattern (square), a simulation was made for eight types of the concavo-convex structure in the lattice pattern (square) which included the convexity formed of SiO₂ (refractive index: 1.45), and which had a height from 0.3 µm to 1.0 µm different 0.1 µm by 0.1 µm. Other conditions were the same as those of the first embodiment. Table 3 and FIG. 12 show the simulation results.

**[Table 3]**

| Concavo-convex Structure | | | | | |
|---|---|---|---|---|---|
| Pitch (µm) | Height (µm) | L&S | Check | Sq. Lattice | Sq. Lattice (SiO₂) |
| 0.3 | 0.3 | 12.6 | 16.4 | 16.7 | 18.1 |
| 0.4 | 0.4 | 12.6 | 16.7 | 17.0 | 18.0 |
| 0.5 | 0.5 | 12.5 | 16.6 | 16.8 | 17.2 |
| 0.6 | 0.6 | 13.0 | 16.3 | 16.3 | 16.3 |
| 0.7 | 0.7 | 13.2 | 16.1 | 15.6 | 16.6 |
| 0.8 | 0.8 | 12.5 | 15.7 | 15.1 | 17.1 |
| 0.9 | 0.9 | 11.6 | 15.5 | 15.1 | 17.6 |
| 1.0 | 1.0 | 11.6 | 15.7 | 15.5 | 17.6 |

| | | | | | |
|---|---|---|---|---|---|
| Flat: Light extraction efficiency was 6.7. Micro-PSS: Light extraction efficiency was 16.2. | | | | | |

It becomes clear from table 3 an FIG. 12 that the concavo-convex shape in the lattice pattern (square) including the convexity formed of SiO₂ accomplishes the highest light extraction efficiency regardless of the height of the concavo-convex structure. In addition, when the height of the concavo-convex structure is equal to or smaller than 0.6 µm, the concavo-convex structures in the checkered pattern and the lattice pattern (square) have a higher light extraction efficiency than that of the micro-PSS conventionally known as having the best light extraction efficiency. Still further, the line-and-space pattern also accomplishes a high light extraction efficiency to some level although not the same level as the micro-PSS. However, the line-and-space pattern has an advantage such that it can be easily processed in comparison with other shapes including the micro-PSS as explained above.

### [Third Example]

Next, a relationship between the inclination of the side wall of the convexity in the concavo-convex structure relative to the diffraction surface and the light extraction efficiency was simulated. The concavo-convex structure had a shape in the planar direction which was a square lattice, had a pitch of 0.5 µm, a height of 0.25 µm, and a width of 0.15 µm at the middle location (height: 0.125 µm) in the height direction. In addition, as illustrated in FIG. 13, the simulation was made for six types that had the inclination of the side wall of the convexity in the concavo-convex structure relative to the diffraction surface within 65-90 degrees and different 5 degrees by 5 degrees. Other conditions were the same as those of the first example. Table 4 and FIG. 14 show the simulation results.

**[Table 4]**

| Concavo-convex Structure | | | Light Extraction Efficiency |
|---|---|---|---|
| Pitch (µm) | Height (µm) | Angle | Square Lattice |
| 0.5 | 0.25 | 90 | 16.21 |
| 0.5 | 0.25 | 85 | 16.19 |
| 0.5 | 0.25 | 80 | 16.14 |
| 0.5 | 0.25 | 75 | 16.05 |
| 0.5 | 0.25 | 70 | 15.91 |
| 0.5 | 0.25 | 65 | 15.68 |

It becomes clear from table 4 and FIG. 14 that the greater the angle of the concavo-convex structure is, the higher the light extraction efficiency is accomplished.

### [Fourth Embodiment]

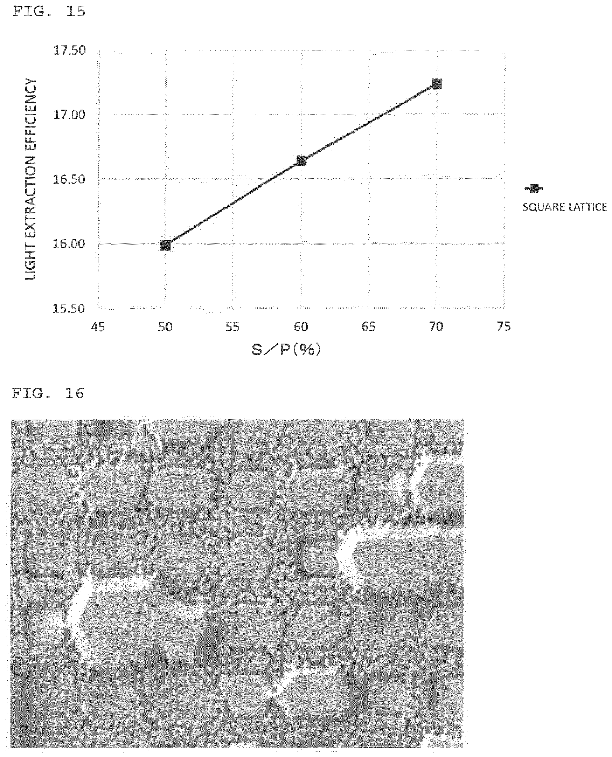

Next, a relationship between the ratio S/P of the width S of the concavity relative to the pitch P of the concavo-convex structure in the shortest pitch direction on the diffraction surface and the light extraction efficiency was simulated. The concavo-convex structure had the shape in the planar direction that was a square lattice, had the pitch of 0.5 µm, and the height of 0.5 µm. Next, the simulation was made for three types that were cases in which the ratio S/P was 50 %, 60 %, and 70 % where S was the width of the concavity and P was the pitch of the concavo-convex structure in the shortest pitch direction. Other conditions were the same as those of the first example. Table 5 and FIG. 15 show the simulation results.

**[Table 5]**

| Concavo-convex Structure | | | | Light Extraction Efficiency |
|---|---|---|---|---|
| Pitch (µm) | Height (µm) | Width of Concavity (µm) | S/P (%) | Square Lattice |
| 0.5 | 0.5 | 0.35 | 70 | 17.23 |
| 0.5 | 0.5 | 0.3 | 60 | 16.64 |
| 0.5 | 0.5 | 0.25 | 50 | 15.99 |

It becomes clear from table 5 and FIG. 15 that the larger the ratio S/P of the concavo-convex structure is, the higher the light extraction efficiency is accomplished.

### [Fifth Embodiment]

Next, an explanation will be given of the results of actually producing the concavo-convex structure according to the present disclosure with reference to photographs that are FIGS. 16-18. As for the concavo-convex structure, first, a resist was applied on a sapphire substrate, and a mask including the concavo-convex structure was formed by imprinting. Next, etching was performed on the sapphire substrate using the mask, and convexities in a square shape that had a side of an upper surface which was 300 nm, and a height of 500 nm were formed in a lattice pattern at the pitch of 1 µm. Next, gallium nitride (GaN) was grown on the concavo-convex structure, and thus the concavo-convex structure according to the present disclosure was produced. FIG. 16 is a planar photograph while gallium nitride (GaN) was grown on the concavo-convex structure formed on the sapphire substrate. As shown in FIG. 16, it becomes clear that gallium nitride (GaN) was selectively subjected to crystal growth in the concavity, and the growth advanced in the horizontal direction after the selective growth reached the upper surface.

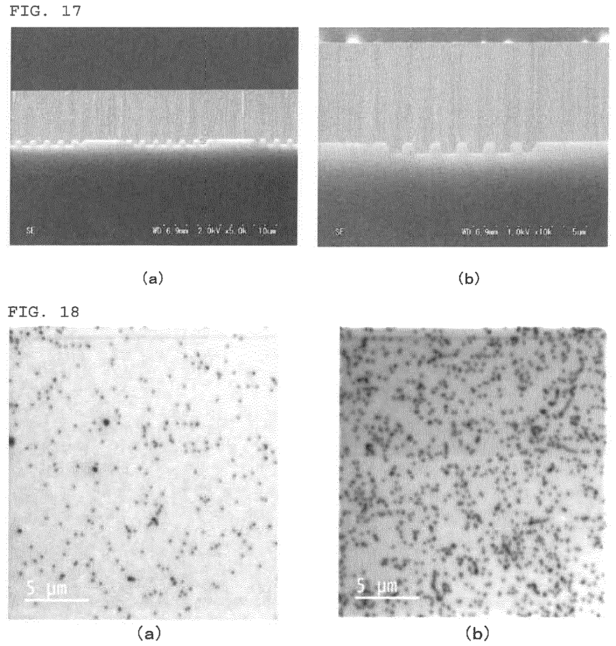

Next, FIG. 17 is a cross-sectional photograph showing the concavo-convex structure formed in this manner. It becomes clear that the concavities of the sapphire substrate were completely filled with gallium nitride (GaN). In addition, the concavo-convex structure was formed in such a way that the inclination of the side wall of the convexity relative to the diffraction surface was 75-80 degrees.

FIG. 18A is a planar photograph obtained through a cathode luminescence scheme indicating the transposition of a gallium nitride layer formed in this manner. The transposition density was 6.1 × 10⁷ cm⁻². For comparison, FIG. 18B is a planar photograph when a gallium nitride layer was formed on a flat sapphire substrate. In this case, the transposition density was 2.0 × 10⁸ cm⁻². That is, it becomes clear that the transposition density of the gallium nitride layer formed on the concavo-convex structure according to the present disclosure is reduced in comparison with that of the gallium nitride layer formed on the flat sapphire substrate.

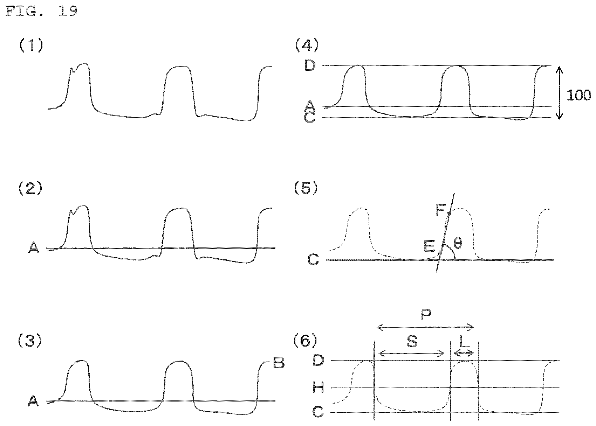

Note that in this specification, the inclination of the convexity in the concavo-convex structure, the pitch P thereof, the width S of the concavity, and the height of the concavo-convex structure, etc., have been explained, but actual light emitting devices have concavities and convexities on the diffraction surface in a microscopic sense, and the concavities and convexities are not uniform since those have a distortion, etc. Basically, in fully view of the significances of the diffraction surface and the concavo-convex structure, the inclination of the convexity in the concavo-convex structure, the pitch P thereof, the width S of the concavity, and the height h of the concavo-convex structure are defined, but when there is a doubt, a measurement may be made as explained below and as illustrated in FIG. 19 to define the dimensions. In this case, also, the significances of the diffraction surface and the concavo-convex structure should be in full consideration.
(1) Pick up a cross-sectional photograph that traverses the laminated part by a plane including a straight line in the shortest pitch direction of the concavo-convex structure by a Scanning Electron Microscope (SEM):
(2) Roughly taking the direction of the diffraction surface into consideration, measure points on the boundary of the concavo-convex structure from the cross-sectional photograph, and calculate by a least square scheme to draw an approximated straight line A;
(3) With reference to the approximated straight line A, measure the height of the boundary of the concavo-convex structure in the cross-sectional photograph, obtain an average of the height on the approximated straight line A at the interval of 10 nm, and perform smoothing by linear interpolation. Accordingly, a reference concavo-convex line B that has peculiar defects and distortions eliminated is created;
(4) Relative to the concavity and convexity on the reference concavo-convex line B across the side wall subjected to an inclination measurement, determine a straight line C that passes through the minimum value of the height of the reference concavo-convex line B with reference to the approximated straight line A, and a straight line D that passes through the maximum value of the height. The straight lines C, D are in parallel with the approximated straight line A. Set the gap between the straight line C and the straight line D as the height h of the concavo-convex structure;
(5) Define the height of the straight line C as zero, and the height of the straight line D as 100. Next, determine a straight line G that interconnects a point E at the height of the reference concavo-convex line B and a point F at the height of 90. Define the inclination of the straight line C relative to the straight line G as an inclination θ of the side wall of the convexity relative to the diffraction surface; and
(6) Determine a straight line H in parallel with the straight line C and at the height of 50, and define the width of the concavity on this straight line as S, the width of the convexity as a line width L, and a total of the width S of the concavity and the line width L as the pitch P.

### REFERENCE SIGNS LIST

- 1: Light emitting device
- 2: Diffraction surface
- 8: Laminated part
- 20: Concavo-convex structure
- 21: Convexity
- 22: Concavity
- 70: Sapphire substrate
- 84: Light emitting layer
- P: Pitch
- S: Width of concavity

## Claims

1. A light emitting device comprising:
a laminated part where a semiconductor layer including a light emitting layer is laminated; and
a diffraction surface comprising a concavo-convex structure which is formed at a boundary of any layer in the laminated part, and which reflects incident light emitted by the light emitting layer in accordance with a Bragg's diffraction condition,
wherein the concavo-convex structure is formed in such a way that an inclination of a side wall of a convexity relative to the diffraction surface is greater than 75 degrees.

2. The light emitting device according to claim 1, wherein the diffraction surface comprises the concavo-convex structure arranged in a lattice pattern.

3. The light emitting device according to claim 2, wherein the diffraction surface comprises the concavo-convex structure arranged in the lattice pattern that is in a polygonal shape.

4. The light emitting device according to claim 2, wherein the diffraction surface comprises the concavo-convex structure arranged in the lattice pattern that is in a rectangular or square shape.

5. The light emitting device according to any one of claims 2-4, wherein the diffraction surface comprises a plurality of regions that have different directions of the lattice in the concavo-convex structure.

6. The light emitting device according to any one of claims 2-4, wherein the diffraction surface comprises a plurality of regions that have directions of the lattice in the concavo-convex structure different equal angle by equal angle.

7. The light emitting device according to any one of claims 1-6, wherein the diffraction surface has a ratio S/P that is equal to or greater than 60 % where S is a width of a concavity and P is a pitch of the concavo-convex structure in a shortest pitch direction.

8. The light emitting device according to claim 1, wherein the diffraction surface comprises the concavo-convex structure arranged in a checkered pattern.

9. The light emitting device according to claim 8, wherein the diffraction surface comprises the concavo-convex structure arranged in the checkered pattern in a polygonal shape.

10. The light emitting device according to claim 8, wherein the diffraction surface comprises the concavo-convex structure arranged in the checkered pattern in a rectangular or square shape.

11. The light emitting device according to any one of claims 8-10, wherein the diffraction surface comprises a plurality of regions that have different directions of the checkered pattern in the concavo-convex structure.

12. The light emitting device according to claim 9 or 10, wherein the diffraction surface comprises a plurality of regions that have directions of the checkered pattern in the concavo-convex structure different equal angle by equal angle.

13. The light emitting device according to claim 1, wherein the diffraction surface comprises the concavo-convex structure arranged in a line-and-space pattern.

14. The light emitting device according to claim 13, wherein the diffraction surface comprises a plurality of regions that have different directions of the line-and-space pattern in the concavo-convex structure.

15. The light emitting device according to claim 13, wherein the diffraction surface comprises a plurality of regions that have directions of the line-and-space pattern in the concavo-convex structure different equal angle by equal angle.

16. The light emitting device according to any one of claims 5, 6, 11, 12, 14, and 15, wherein the diffraction surface comprises the plurality of regions that have different directions of the concavo-convex structure, the plurality of regions being arranged in such a way that the regions with the same direction of the concavo-convex structure are in sequence.

17. The light emitting device according to any one of claims 1-16, wherein the diffraction surface has a pitch of the concavo-convex structure which is equal to or greater than 1/4 times as much as an optical wavelength of the incident light.

18. The light emitting device according to any one of claims 1-17, wherein the diffraction surface has a pitch of the concavo-convex structure which is equal to or smaller than 12 times as much as an optical wavelength of the incident light.

19. The light emitting device according to any one of claims 1-18, wherein the diffraction surface has a height of the concavo-convex structure which is equal to or greater than 0.1 µm.

20. The light emitting device according to any one of claims 1-19, wherein the diffraction surface has a height of the concavo-convex structure which is equal to or smaller than 1.5 µm.

21. The light emitting device according to any one of claims 1-20, wherein:
the concavo-convex structure is formed between a substrate and the semiconductor layer; and
at least a part of the concavo-convex structure is formed of a material that accomplishes a difference in refractive index between the semiconductor layer and the concavo-convex structure greater than a difference in refractive index between the substrate and the semiconductor layer.

22. The light emitting device according to any one of claims 1-20, wherein:
the concavo-convex structure is formed between a sapphire substrate and the semiconductor layer; and
at least a part of the concavo-convex structure is formed of silicon dioxide (SiO₂) or silicon oxynitride (SiON).
